Europäisches Patentamt

European Patent Office

Office européen des brevets

(11) Publication number: **0 139 998**
**B1**

(12) **EUROPEAN PATENT SPECIFICATION**

(45) Date of publication of patent specification: **01.04.87**

(21) Application number: **84110162.9**

(22) Date of filing: **25.08.84**

(51) Int. Cl.⁴: **H 01 L 29/74,** H 01 L 29/78,
H 01 L 29/60

(54) **Power semiconductor device with main current section and emulation current section.**

(30) Priority: **06.09.83 US 529240**

(43) Date of publication of application:
**08.05.85 Bulletin 85/19**

(45) Publication of the grant of the patent:
**01.04.87 Bulletin 87/14**

(84) Designated Contracting States:
**CH DE FR GB IT LI NL SE**

(56) References cited:
**GB-A-2 082 385**

**INTERNATIONAL ELECTRON DEVICES
MEETING, TECHNICAL DIGEST, 13th-15th
December 1982, San Francisco, CA., pages
264-267, IEEE, New York, US; B.J. BALIGA et
al.: "The insulated gate rectifier (IGR): A new
power switching device"**

**INTERNATIONAL ELECTRON DEVICES
MEETING, TECHNICAL DIGEST, 8th-10th
December 1980, Washington, D.C., pages 75-
76, IEEE, New York, US; J. TIHANYI:
"Functional integration of power MOS and
bipolar devices"**

(73) Proprietor: **GENERAL ELECTRIC COMPANY
1 River Road
Schenectady New York 12305 (US)**

(72) Inventor: **Walden, John Palmer
1930 Clifton Park Road
Schenectady, N.Y. 12309 (US)**
Inventor: **Wildi, Eric Joseph
39 Canterbury Road
Clifton Park New York 12065 (US)**

(74) Representative: **Schüler, Horst, Dr. European
Patent Attorney et al
Kaiserstrasse 41
D-6000 Frankfurt/Main 1 (DE)**

Courier Press, Leamington Spa, England.

# Description

## Background and summary of the invention

The present invention relates to a power semiconductor device having a main current section and an emulation current section that emulates, or follows, the current in the main current section.

Power semiconductor devices are devices designed to carry power level electrical current, such as current for powering an alternating current motor. Known types of these power devices comprise a plurality of active region cells contracted by two common main electrodes (cf. e.g. GB—A—2082385). It is often useful to limit the current in power devices for one of two basic reasons. First the power device may have an internal current limit above which the device switches into an undesirable mode of operation, possibly destructive to the power device. Second, the electrical system in which the power device is utilized may be able to tolerate only a particular maximum current level in the power device, above which deleterious circuit behavior results in the system.

In order to be able to limit current in a power semiconductor device, the device current level must first be sensed. One prior art technique of sensing current level in a power device involves sensing the voltage drop developed across a resistor that is serially connected to the power device. Unfortunately, the sensing resistor must be rated for a considerable level of power, and thereby results in an increased expense of current sensing.

Accordingly, an object of the present invention is to provide a power semiconductor device in which the device current level can be sensed with low power circuitry.

A further object of the invention is to provide a power semiconductor device in which the device current can be sensed economically and with high accuracy.

Another object of the invention is to provide a power semiconductor device in which low current emulation of the device current level is achieved without increasing the number of device fabrication steps. In accordance with the present invention, there is provided a power semiconductor device with a main current section and an emulation current section comprising a plurality of active (i.e. current-carrying) region cells. At least one of said cells constitutes a main current section and at least one further of said cells constitutes an emulation current section. A first cathode contacts the main current section, while a separate, second cathode contacts the emulation current section. A common anode contacts both the main current section and the emulation current section.

In accordance with a preferred embodiment of the invention, there is provided a power semiconductor device having a plurality of substantially identical active region cells and a device termination region. A majority of the active region cells constitute a main current section and a minority of the active region cells constitute an emulation current section. The device termination region is common to, and surrounds both the main current section and the emulation current section in the preferred embodiment. A gate is coupled to the main current section and, preferably, to the emulation current section.

The current level in the emulation current section closely emulates the current level in the main current section, owing to close thermal and electrical coupling between these sections, and, further, because they are formed in the same fabrication process. Since the current level in the emulation section constitutes only a fraction of that in the main current section, low power circuitry can be used to sense current in the power device by sensing current in the emulation section. Additionally, the present power device is only slightly more complex than a device without an emulation current section; accordingly, resulting economical current sensing is made possible by the present invention.

## Brief description of the drawings

The features of the invention deemed to be novel are defined in the appended claims. The invention itself, however, both as to organization and method of operation, together with further objects and advantages thereof, may best be understood with reference to the following description when read in conjunction with the accompanying drawings, in which:

Figure 1 is a tridimensional view of an exemplary power semiconductor device in accordance with the present invention;

Figure 2 is a cross-sectional view of the device of Figure 1 taken along line 2—2 of Figure 1; and

Figure 3 is a simplified top plan view of a further power semiconductor device in accordance with the present invention.

## Description of the preferred embodiments

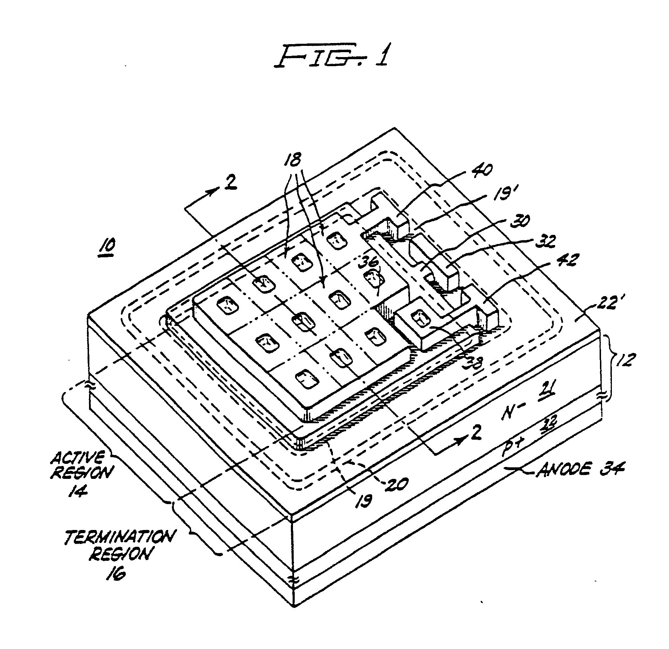

There is shown in Figure 1 a preferred power semiconductor device 10 in accordance with the present invention. Device 10 comprises a semiconductor wafer 12, such as silicon, including an active, or current-carrying, region 14 and a termination region 16 surrounding active region 14 and extending outward to the edge of the device.

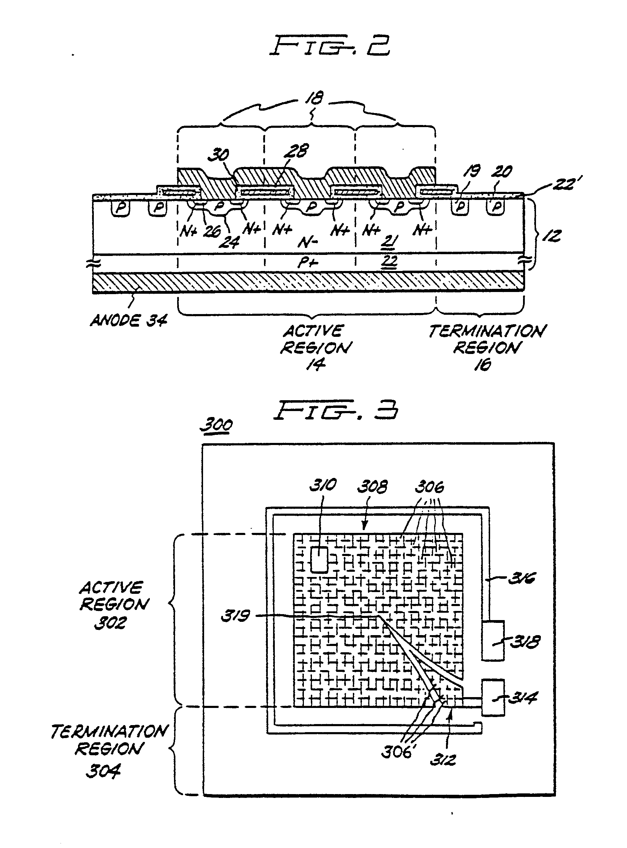

Active region 14 preferably contains a plurality of cells 18, suitably identical to each other, that are schematically depicted by dashed-line squares. Termination region 16 includes, as essential elements, guard ring 19 and field ring 20 (both shown in dashed lines) or any other suitable termination structure for power devices as will be apparent to those skilled in the art. Further details of an examplary termination region 16 and an exemplary structure for cells 18 are illustrated in the cross-sectional view of Figure 2, which is taken along line 2—2 in Figure 1. In Figure 2, guard ring 19 and field ring 20 of termination region 16 can be seen to comprise respective P-conductivity type regions adjoining the upper portion of an N-conductivity type region 21. An oxide or other insulating layer 22' covers guard ring 19, field ring 20 and N-type layer 21. Cells 18 of active region 14 are shown as each constituting a cell of an insulated gate transistor (IGT), a device that is described (albeit with a different name) in an article by B. J. Baliga, M. S. Adler, P. V. Gray and R. P. Love, entitled "The Insulated Gate Rectifier (IGR): A New Power Switching Device", IEDM 82 (December 1982), pages 264—267, which is incorporated herein by reference. The leftmost IGT cell 18 in Figure 2 comprises a highly-doped, P-conductivity type region 22, preferably a bulk substrate which is overlaid by lightly-doped N-conductivity type region 21, which is preferably grown epitaxially on P-conductivity type region 22. N-conductivity type region 21, in turn, is overlaid by a P-conductivity type region 24, which typically comprises two portions of different resistivity. P-conductivity type region 24, in turn, is overlaid by a highly-doped N-conductivity type region 26. P region 24, when viewed from above, is suitably configured with a rectangular or circular boundary, for example, while N region 26, when viewed from above, is suitably configured as a rectangular or circular loop within P region 24, for example. A gate 28, shown in simplified form, preferably comprises a common gate for each of cells 18 and may be formed of conductive polysilicon or other conductive refractory material. Gate 28 is spaced from the upper surface of wafer 12 by silicon dioxide or other insulating layer(s) 30, which also covers the top and sides of gate 28. The other cells 18 are suitably identical to the just-described, leftmost cell 18.

Referring again to Figure 1, a portion of gate 28, (not visible) that is covered by oxide 30 suitably contacts a metallic bonding pad 32, which is separated from an enlarged portion 19' of guard ring 19 by oxide or other insulating layer 22'. On the underside of wafer 12 is an anode 34, suitably comprising a deposited metal such as aluminum and constituting a common anode for each of cells 18. In accordance with the present invention, two separate cathodes 36 and 38 are provided. Cathode 36 contacts a majority of cells 18 of active region 14, while cathode 38 contacts a minority of cells active region 14 (that is, in device 10, only one cell).

Cathode 36 is connected to a bonding pad 40, which is separated from enlarged guard ring portion 19' by oxide 22', but in the preferred embodiment directly contacts enlarged guard ring portion 19', which then would be at the same voltage as cathode 36.

The cells 18 that are contacted by cathode 36 constitute what is referred to herein as a "main current section", and the cell 18 that is contacted by cathode 38 constitutes what is referred to herein as an "emulation current section". In fabricating power semiconductor device 18 comprising IGT cells 18, conventional processing techniques for fabricating an IGT with a single cathode and a single pad therefor may be employed with an essential alteration being that two cathodes 36 and 38 and their corresponding bonding pads 40 and 42 must be provided. This can be readily accomplished by modifying the cathode-defining mask (not shown) when cathode metallization is deposited on wafer 12 in a manner well-known to those skilled in the art so that it defines two cathodes and two bonding pads. No increase in the number of fabricating steps results, and power semiconductor device 10 is only slightly more complex than a power semiconductor device having a single cathode and a single bonding pad connected thereto. Accordingly, power device 10 may be made for only a slight increase in cost over a conventional device.

In operation of power semiconductor device 10, the current level in the emulation current section of the device is closely proportional to the current level in the main current section of the device, since these sections are closely coupled both thermally and electrically and, further, because these sections are formed in the same fabrication process. In regard to the thermal coupling, when the main current section fluctuates in temperature, for example, rising in temperature during current conduction, the temperature of the emulation current section closely follows the main current section temperature due to the proximity of these sections. With regard to the close electrical coupling of these sections, gate 28 (Figure 2), when commonly interconnected to both of the sections provides a short electrical path between the respective gate portions for each section, and, similarly, anode 34 provides a short electrical path between both of the sections. This minimizes any parasitic capacitance or inductance that is inherent in the interconnecting electrical paths between the respective gate and anode portions of the main current section and the emulation current section. For reasons that will be apparent to those skilled in the art, this close thermal and electrical coupling results in the current level in the emulation current section being closely proportional to the current level in the main current section, especially during dynamic device operating conditions, such as when device 10 rapidly turns on and off. A further advantage of power device 10 is that the level of current in the main current section can be sensed by external circuitry (not shown) of a low power rating. This is because only a fraction of the current of device 10, that is, the current in the emulation current section, needs to be sensed in order to determine the current level in the main current section.

Power semiconductor device 10 can be modified in various ways and still function in accordance with the present invention. For example, the emulation current section could be formed in wafer 12 at a distal location from the active region. This, however, results in more space on wafer 12 being used since separate device termination regions would be required for both the main and emulation current sections, in contrast to device termination region 16 of power device 10, which is common to both the main and emulation current sections. Additionally, gate 28 (Fig. 2) could be separated into two gate sections, one for the main current section and one for the emulation current section. This would permit independent control of the main and emulation current sections by the respective gates. Moreover, the emulation current section cell or cells can be different in size and structure than the cells of the main current section. A different cell size does not result in loss of current emulation by the emulation current section, but changes the fraction of device current conducted by the emulation current section. With regard to cell structure, emulation current section cells could be formed without either or both of gate 28 (Fig. 2) and N-conductivity region 26 (Fig. 2). Further, while cells 18 of power device 10 have been particularly described as IGT cells, cells 18 could comprise other power device cells, such as Metal-Oxide-Semiconductor Field-Effect Transistor (MOSFET) cells or MOS-gated thyristor cells. Power device 10 could alternatively comprise a power bipolar transistor or a power P-I-N diode, in either of these cases with the main current section and the emulation current section each preferably comprising a single cell, different in size from the other. Furthermore, power device 10 could comprise more than one emulation current section if desired, for example, to simplify external current sensing circuitry (not shown). With regard to MOSFETs and bipolar transistors, "anode" as used herein is intended to signify the drain contact of a MOSFET as well as the collector contact of a bipolar transistor; "cathode" as used herein is intended to signify the source contact of a MOSFET as well as the emitter contact of a bipolar transistor; and "gate" as used herein is intended to signify the control contact of a MOSFET as well as the base contact of a bipolar transistor.

In accordance with a further embodiment of the invention, a power semiconductor device 300 is shown in simplified, top plan view in Figure 3. Device 300 includes an active region 302 and a device termination region 304 surrounding active region 302 and extending to the periphery of the device. Termination region 304 comprises any suitable termination region such as described above with regard to device 10 of Figure 1. Active region 302 includes a multiplicity of cells 306 and 306′ schematically shown as individual squares. Cells 306 and 306′ may each comprise IGT cells or MOSFET cells, by way of example.

Power semiconductor device 300 includes a main cathode 308 connected to a bonding pad area 310 located above active region 302. Device 300 further includes a separate emulation cathode 312, which is connected to a bonding pad 314 located above termination region 304. Main cathode 308 contacts cells 306 that constitute a main current section, and emulation cathode 312 contacts cells 306′ that constitute an emulation current section. Device 300 also includes a gate (not shown), preferably of conductive polysilicon, which is coupled to cells 306 and 306′ and which

is connected to a metallic gate ring 316 and, thence, to gate bonding pad 318, both metallic gate ring 316 and gate bonding pad 318 being located over termination region 304. During turn-on of power semiconductor device 300, a control voltage is applied by external circuitry (not shown) to gate bonding pad 318, and, thence, to metallic gate ring 316. Such control voltage is transmitted from metallic gate ring 316 towards the center 319 of active region 302, first, through a conductive structure interconnecting metallic gate ring 316 and the gate (not shown) and, second, through the gate. Transfer of the voltage through a polysilicon gate conductor is slower than through a metal such as metallic gate ring 316, due to the greater electrical resistance of the polysilicon that interreacts with the capacitance of the gate coupled to each of cells 306 and 306′. Accordingly, the cells at a large radial distance from center 319, for example at the periphery of active region 302, turn on before the lesser number of cells at a lesser radial distance from center 319. In accordance with the invention, emulation cathode 312, which contacts cells 306′ of the emulation current section, is configured in such a way as to contact a larger number of cells 306′ at a greater radial distance from center 316 than at a lesser radial distance. This results in the emulation current section turning on at approximately the same rate as the main current section. An optimal configuration for emulation cathode 312 will be readily determinable by those skilled in the art.

The foregoing describes various embodiments of a power semiconductor device having a main current section and an emulation current section, which beneficially conducts only a fraction of the current of the main current section. Additionally, the emulation current section beneficially permits current sensing of device current level with low power circuitry and may be economically provided in the device.

**Claims**

1. A power semiconductor device (10; 300) with a main current section and an emulation current section, comprising:
   a plurality of active region cells (18; 306, 306′), at least one of said cells constituting a main current section and at least one further of said cells constituting an emulation current section;
   a common anode (34) contacting said main current section and said emulation current section;
   a first cathode (36; 308) contacting said main current section; and
   a second and separate cathode (38; 312) contacting said emulation current section.

2. The power semiconductor device of claim 1 further comprising a common device termination region (16; 304) surrounding both said main current section and said emulation current section.

3. The power semiconductor device of claim 2 further including a first gate coupled to said main current section.

4. The power semiconductor device of claim 3 further including a second gate coupled to said emulation current section.

5. The power semiconductor device of claim 4 wherein said first and second gates comprise a commonly-interconnected gate (28).

6. The power semiconductor device of claim 2 wherein said plurality of cells (18; 306, 306') of said active region (14; 302) comprises cells substantially identical in size and structure to each other a majority of which constitute the main current section and a minority of which constitute the emulation current section.

7. The power semiconductor device of claim 2 in which said second cathode (312) contacts a larger number of emulation current section cells (306') at a greater radius from the center of said active region that at a lower radius, whereby the current level in said emulation current section is closely proportional to the current level in said main current section during device turn-on and turn-off.

8. The power semiconductor device of claim 2 wherein said active region cells (18; 306, 306') each comprise Insulated Gate Transistor cells.

9. The power semiconductor device of claim 2 wherein said active region (14; 302) comprises silicon semiconductor material.

**Patentansprüche**

1. Leistungs-Halbleitervorrichtung (10; 300) mit einem Hauptstromabschnitt und einem Emulationsstromabschnitt, enthaltend:

mehrere Aktivbereichszellen (18; 306, 306'), wobei wenigstens eine der Zellen einen Hauptstrombereich und wenigstens eine weitere der Zellen einen Emulationsstromabschnitt bildet,

eine gemeinsame Anode (34), die den Hauptstromabschnitt und den Emulationsstromabschnitt kontaktiert,

eine erste Kathode (34; 308), die den Hauptstromabschnitt kontaktiert, und

eine zweite und getrennte Kathode (38; 312), die den Emulationsstromabschnitt kontaktiert.

2. Leistungs-Halbleitervorrichtung nach Anspruch 1, wobei ein gemeinsamer Anschlußbereich (36; 304) der Vorrichtung vorgesehen ist, der sowohl den Hauptstromabschnitt als auch den Emulationsstromabschnitt umgibt.

3. Leistungs-Halbleitervorrichtung nach Anspruch 2, wobei ein Gate vorgesehen ist, das mit dem Hauptstromabschnitt verbunden ist.

4. Leistungs-Halbleitervorrichtung nach Anspruch 3, wobei ein zweites Gate vorgesehen ist, das mit dem Emulationsstromabschnitt verbunden ist.

5. Leistungs-Halbleitervorrichtung nach Anspruch 4, wobei die ersten und zweiten Gates ein gemeinsam verbundenes Gate (28) aufweisen.

6. Leistungs-Halbleitervorrichtung nach Anspruch 2, wobei die mehreren Zellen (18; 306, 306') des Aktivbereiches (14; 302) Zellen aufweisen, die in Größe und Struktur zueinander im wesentlichen identisch sind, wobei eine größere Anzahl davon den Hauptstromabschnitt und eine kleinere Anzahl davon den Emulationsstromabschnitt bilden.

7. Leistungs-Halbleitervorrichtung nach Anspruch 2, wobei die zweite Kathode (312) eine größere Anzahl von Emulationsstromzellen (306') auf einem größeren Radius von der Mitte des Aktivbereiches als auf einem kleineren Radius kontaktiert derart, daß die Größe des Stroms in dem Emulationsstromabschnitt während des Durchschaltens und Sperrens der Vorrichtung eng proportional zu der Größe des Stroms in dem Hauptstromabschnitt ist.

8. Leistungs-Halbleitervorrichtung nach Anspruch 2, wobei die Aktivbereichszellen (18; 306, 306') jeweils Oberflächen-Transistorzellen aufweisen.

9. Leistungs-Halbleitervorrichtung nach Anspruch 2, wobei der Aktivbereich (14; 302) Siliziumhalbleitermaterial aufweist.

**Revendications**

1. Dispositif semi-conducteur de puissance (40; 300) avec une section à courant principal et une section à courant d'émulation, comprenant:

une multitude de cellules à région active (48; 306, 306'), au moins l'une des cellules constituant une section à courant principal et au moins une autre des cellules constituant une section à courant d'émulation;

une anode commune (34) en contact avec la section à courant principal et la section à courant d'émulation;

une première cathode (36; 308) en contact avec la section à courant principal; et

une seconde cathode séparée (38; 312) en contact avec la section à courant d'émulation.

2. Dispositif semi-conducteur de puissance selon la revendication 1, comprenant en outre une région commune de terminaison (16; 304) du dispositif qui entoure la section à courant principal ainsi que la section à courant d'émulation.

3. Dispositif semi-conducteur de puissance selon la revendication 2, comportant en outre une première grille couplée à la section à courantprincipal.

4. Dispositif semi-conducteur de puissance selon la revendication 3, comportant en outre une seconde grille couplée à la section à courant d'émulation.

5. Dispositif semi-conducteur de puissance selon la revendication 4, dans lequel les première et seconde grilles comprennent une grille interconnectée en commun (28).

6. Dispositif semi-conducteur de puissance selon la revendication 2, dans lequel la multitude de cellules (18; 306, 306') de la région active (14; 302) comprennent des cellules sensiblement identiques en dimensions et en structure les unes aux autres, dont une majorité constitue la section à courant principal et une minorité constitue la section à courant d'émulation.

7. Dispositif semi-conducteur de puissance selon la revendication 2, dans lequel la seconde cathode (342) est en contact avec un grand nombre de cellules (306') de la section à courant d'émulation à un rayon par rapport au centre de la région active plus grand qu'à un rayon plus petit, d'où il résulte que la valeur du courant dans la section à courant d'émulation est étroitement proportionnelle à la valeur du courant dans la section à courant principal pendant la venue à l'état conducteur et à l'état non-conducteur du dispositif.

8. Dispositif semi-conducteur de puissance selon la revendication 2, dans lequel les cellules (18; 306, 306') de la région active comprennent chacune des cellules de transistor à grille isolée.

9. Dispositif semi-conducteur de puissance selon la revendication 2, dans lequel la région active (14; 302) est constituée d'une matériau semi-conducteur en silicium.

FIG. 1

0 139 998

FIG. 2

18

30  28  19  20  22'

P  P  P  P  P  P  P

N+ 26  N+  N+  N+  N+  21  N+

24  N-  22

P+

12

ANODE 34

ACTIVE
REGION
14

TERMINATION
REGION
16

FIG. 3

300

310  308  306

316

ACTIVE
REGION
302

319

318

314

TERMINATION
REGION
304

306'  312

2